# EUROPEAN PATENT SPECIFICATION

(11) **EP 0 574 094 B1**
(45) Date of publication and mention of the grant of the patent: **11.12.1996**
(21) Application number: 93202350.0
(22) Date of filing: 20.02.1989
(51) Int. Cl.: G11C 7/00

(54) **Memory devices**
Speichervorrichtungen
Dispositifs de mémoire

(30) Priority: 19.02.1988 JP 36711/88; 19.02.1988 JP 36712/88; 20.02.1988 JP 37908/88
(43) Date of publication of application: 15.12.1993
(62) Divisional of application: 89301639.4
(73) Proprietor: SONY CORPORATION, Tokyo 141 (JP)
(72) Inventor: Miyaji, Fumio, c/o Patents Division, Shinagawa-ku, Tokyo 141 (JP)
(74) Representative: Pilch, Adam John Michael

(56) References cited:
- EP-A- 0 149 043
- EP-A- 0 182 353
- EP-A- 0 189 700
- PATENT ABSTRACTS OF JAPAN vol. 6, no. 166 (P-138)31 August 1982 & JP-A-57 081 665 (TOSHIBA CORP.)

## Description

This invention relates to semiconductor memory devices such as a static random access memory (RAM) device.

A semiconductor memory device such as a static RAM (SRAM) which has a high speed read-out function is already known, for example as disclosed in Japanese Patent Application Publication No. JP-A-54-148 442, wherein high speed operation is attained by suitably controlling variable load means provided at terminal ends of bit lines (data lines).

A random access memory device such as an SRAM device may be equipped with a flash clear function. According to this function, when a single control signal is fed from an external circuit, either "0" or "1" is written into all of the memory cells of the memory device at a time. Therefore, this function can be utilised for initialising the memory device for resetting or testing.

In a typical random access memory device, flash clear is executed simultaneously for an entire memory cell array of the memory device. This raises the problem that current flow upon flash clear presents a critically high peak value.

In fact, the storage capacity of memory devices has been increasing significantly in recent years and memory cell arrays are tending towards a large scale. If a large scale memory cell array is cleared at one time, the peak current flow in the memory device amounts to an extremely high value. Increase of the peak current will naturally cause considerable variation in level of a power supply line or a ground line. Accordingly, there is the possibility that noise may be produced or conductors in the integrated circuit (IC) chip may be fused, causing destruction of the inner structure of the chip or destruction of an appliance in which the memory device is used.

In view of such circumstances, several proposals have been made wherein a memory cell array is segmented into a plurality of memory cell groups to each of which a batch writing operation is made successively at different timings. One such proposal is disclosed in our Japanese Patent Application Publication No. JP-A-01-130 385 which is not prepublished.

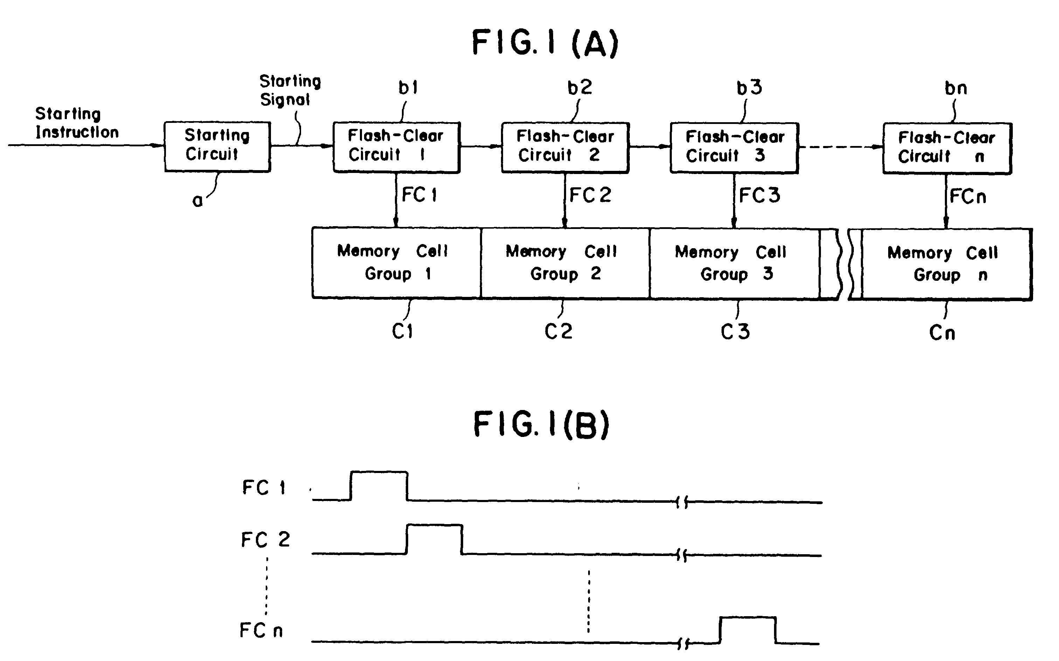

This proposed memory device is shown in the block diagram of Figure 1(A) of the accompanying drawings. Referring to Figure 1(A), the memory device includes a starting circuit a which generates a starting signal in response to a starting instruction signal fed thereto. The memory device further includes a plurality of flash-clear circuits b1, b2, b3 bn which are provided in a corresponding relationship to a plurality of memory cell groups c1, c2, c3 cn which are formed by segmenting a memory cell array into n sections. The starting signal thus generated from the starting circuit a is supplied to the first flash-clear circuit b1, which thus sends a flash-clearing signal FC1 to the first memory cell group cl for flash-clearing the group c1. Meanwhile, the flash-clear circuit bl delays the starting signal received from the starting circuit a and then supplies the delayed signal to the second flash-clear circuit b2. In response to the delayed starting signal from the first flash-clear circuit b1, the second flash-clear circuit b2 delivers a flash-clearing signal FC2 to the memory cell group c2 for flash-clearing the group c2. Meanwhile, the second flash-clear circuit b2 also delays the received starting signal and supplies the delayed signal to the third flash-clear circuit b3. Thus, the memory cells of the memory cell groups c1 to cn are successively flash-cleared in accordance with a predetermined order as seen from the time chart of Figure 1(B) of the accompanying drawings. A memory device of this type presents a significantly lower value of peak current flow upon flash-clearing because the memory cell groups are flash-cleared at different timings.

In such a memory device as shown in Figure 1(A), however, a flash-clear circuit b1 to bn must be provided for each memory cell group c1 to cn. Accordingly, the memory device includes a significant number of flash-clear circuits, which leads to the problem that the area of the chip of the memory device is comparatively large.

A memory according to the preamble of claim 1 is disclosed in JP-A-57 081 665.

According to the invention there is provided a semiconductor memory device having a flash-clear function, the memory device comprising:
a memory cell array segmented into a plurality of memory cell groups; and being characterised by
a single flash-clear circuit provided in common for said plurality of memory cell groups for delivering, during a district flash clearing operation, flash-clearing signals at different timings to respective ones of said plurality of memory cell groups to flash-clear memory cells of said plurality of memory cell groups.

An embodiment of the invention, to be described in greater detail hereinafter, provides a random access memory device which presents a significantly low value of peak current flow therein upon flash-clearing and occupies a comparatively small area on a chip.

In one embodiment of the invention, a starting circuit for the flash-clear circuit includes a latch circuit operable to be set by an input pulse and to deliver a predetermined output pulse, and a charging/discharging circuit for receiving the input pulse, the latch circuit being connected to be reset in response to charging or discharging of the charging/discharging circuit.

The invention will now be described by way of example with reference to the accompanying drawings, throughout which like parts are referred to by like references, and in which:
Figure 1(A) is a circuit block diagram illustrating the general arrangement of a previously-proposed memory device having a flash-clear function;
Figure 1(B) is a time chart illustrating the operation of the memory device shown in Figure 1(A);
Figure 2 is a block circuit diagram of a memory device according to European Patent Application No. EP-A-0 331 322 of which the present application is a divisional application;
Figure 3 is a signal waveform chart illustrating the operation of the memory device shown in Figure 2;
Figure 4 is a block diagram illustrating the basic arrangement of the memory device shown in Figure 2 where the memory device has a flash-clearing function according to an embodiment of the invention;
Figure 5 is a time chart illustrating the flash-clearing signals in the memory device shown in Figure 4;
Figure 6 is a block circuit diagram showing a flash-clearing circuit of the memory device shown in Figure 4;
Figure 7 is a circuit diagram showing an initial data setting/resetting circuit of the memory device shown in Figure 4;
Figure 8 is a circuit diagram showing an initial clearing and count-up clearing circuit of the memory device shown in Figure 4;
Figure 9 is a time chart illustrating the operation of the flash-clearing circuit shown in Figure 6;
Figure 10 is another time chart illustrating the operation of the initial clearing and count-up clearing circuit shown in Figure 8;
Figure 11 is a block diagram illustrating the basic arrangement of a pulse generator for use with the memory device shown in Figure 4;
Figure 12 is a circuit diagram showing a first exemplary circuit construction of the pulse generator shown in Figure 11;
Figure 13 is a waveform chart showing the waveforms of signals in the circuit shown in Figure 12;
Figure 14 is a circuit diagram showing a second exemplary circuit construction of the pulse generator shown in Figure 11; and
Figure 15 is a waveform chart showing the waveforms of signals in the circuit shown in Figure 14.

A memory device, to be described below, is in the form of an SRAM which is manufactured by the complementary metal oxide semiconductor (CMOS) producing process. The memory device attains high speed operation by employing p-channel metal oxide semiconductor (PMOS) transistors as variable load means at terminal ends of bit lines therein.

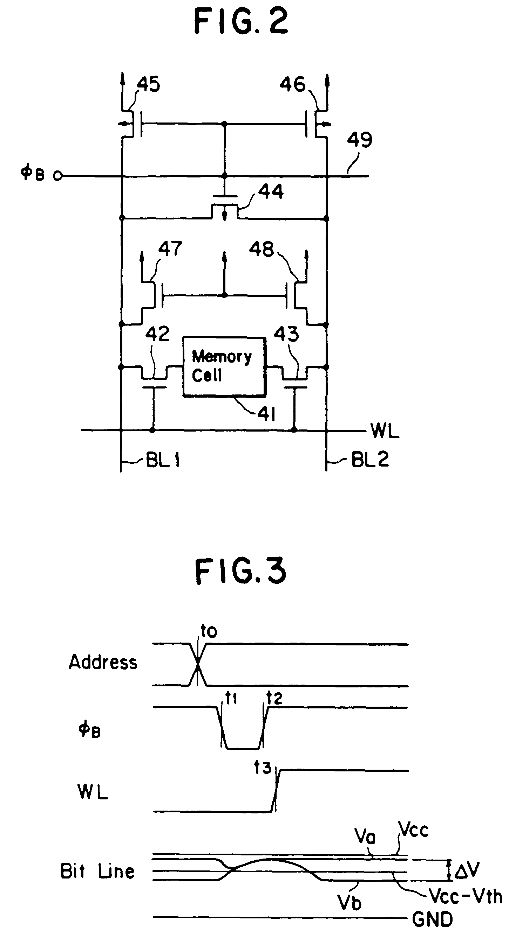

Referring first to Figure 2, detailed circuit construction of part of a memory device according to our European Patent Application No. EP-A-0 331 322 is shown. The memory device includes a plurality of memory cells 41 (only one is shown). Each of the memory cells 41 is disposed between a pair of bit lines BL1 and BL2 and connected via a pair of access transistors 42 and 43 to the bit lines BL1 and BL2, respectively. The access transistors 42 and 43 are each in the form of an n-channel metal oxide semiconductor (NMOS) transistor the gate of which is connected to a word line WL. The memory cells 41 are arranged so as to form a matrix and accordingly, the memory device includes a plurality of pairs of bit lines.

A pair of PMOS transistors 45 and 46 serving as load elements are connected to the terminal ends of the respective bit lines BL1 and BL2. A supply voltage Vcc is supplied to the sources of the PMOS transistors 45 and 46 while the drains of the PMOS transistors 45 and 46 are connected to the bit lines BL1 and BL2, respectively. The gates of the PMOS transistors 45 and 46 are connected to a precharge signal line 49 so as to receive a precharge signal φb from the latter.

In the vicinity of each of the PMOS transistors 45 and 46, there is disposed another PMOS transistor 44 for equalising the bit lines BL1 and BL2. The source and drain of the PMOS transistor 44 are connected to the bit lines BL1 and BL2 while the gate of the PMOS transistor 44 is connected to the precharge signal line 49.

A pair of NMOS transistors 47 and 48 serving as first variable load means are provided for each memory cell 41 and are connected to the bit lines BL1 and BL2, respectively. The gates and drains of the NMOS transistors 47 and 48 are connected in common so as to be supplied with the supply voltage Vcc while the sources thereof are connected to the bit lines BL1 and BL2, respectively.

It is to be noted that the memory cells of the memory device may be either of the high-resistance load type or the complete CMOS type.

Referring to Figure 3, the operation of the memory device shown in Figure 2 is illustrated in a waveform chart. Further details of the operation are described in the above-mentioned EP-A-0 331 322.

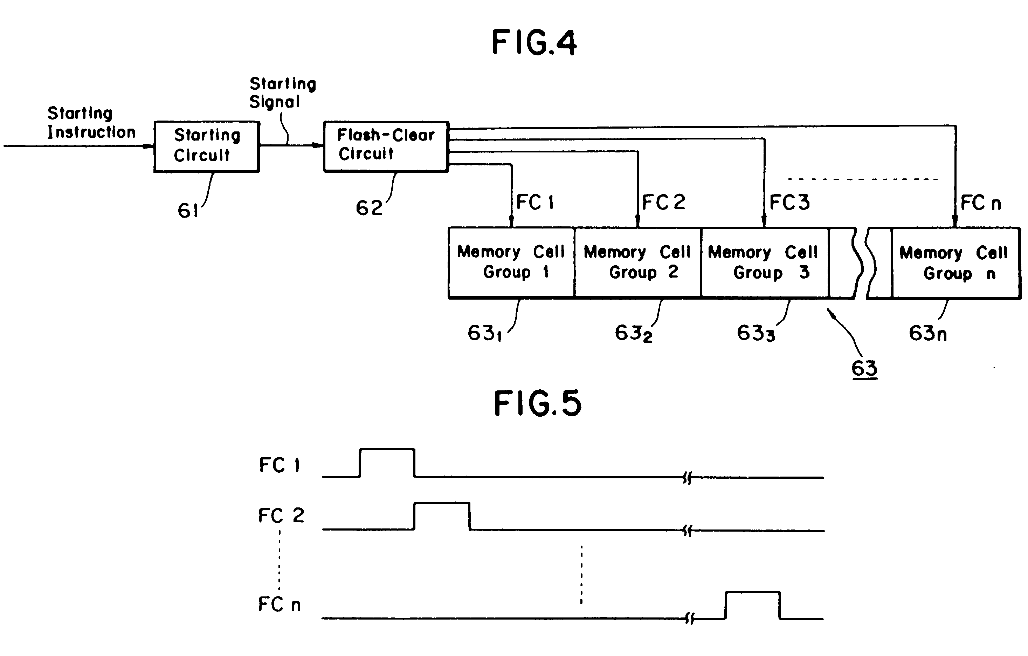

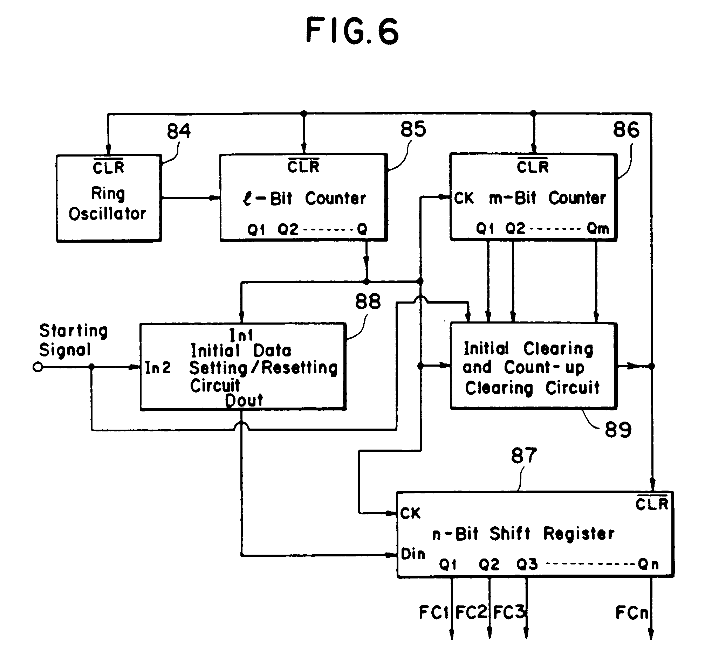

Referring now to Figure 4, there is shown the basic construction of a memory device having an improved flash-clearing function. The memory device includes a starting circuit 61 and a flash-clear circuit 62 which delivers flash clear signals FC1 to FCn to a plurality of memory cell groups 63₁ to 63ₙ of a memory cell array 63 of the memory device, respectively. The flash clear signals FC1 to FCn may have a binary value "1", as shown in Figure 5, and are delivered at successively delayed timings to the memory cell array 63 for a flash-clearing operation.

Due to such successive time lags with which the flash-clear signals FC1 to FCn are delivered to the individual memory cell groups 63₁ to 63ₙ, current flow in the memory device exhibits a significantly lower peak value and only one such flash-clear circuit 62 is required. Consequently, the chip size of the memory device is significantly smaller than in the previous proposals.

Referring now to Figure 6, the detailed construction of the flash-clear circuit 82 is shown. The flash-clear circuit 82 includes a ring oscillator 84 with an oscillation halt function for generating clock pulses CLK which are to be used for the setting of a clear time. The flash-clear circuit 82 further includes an l-bit counter 85 for counting the number of output clock pulses CLK of the ring oscillator 84 to set a clear time, an m-bit counter 86 for counting the number of memory cell groups which constitute the memory cell array 63, an n-bit shift register 87 for successively supplying flash clear signals FC1 to FCn to the memory cell groups 63₁ to 63ₙ with predetermined timing lags, an initial data setting/resetting circuit 88 for supplying initial data to the n-bit shift register 87, and an initial clearing and count-up clearing circuit 89 for clearing the counters 85 and 86, the ring oscillator 84 and the n-bit shift register 87.

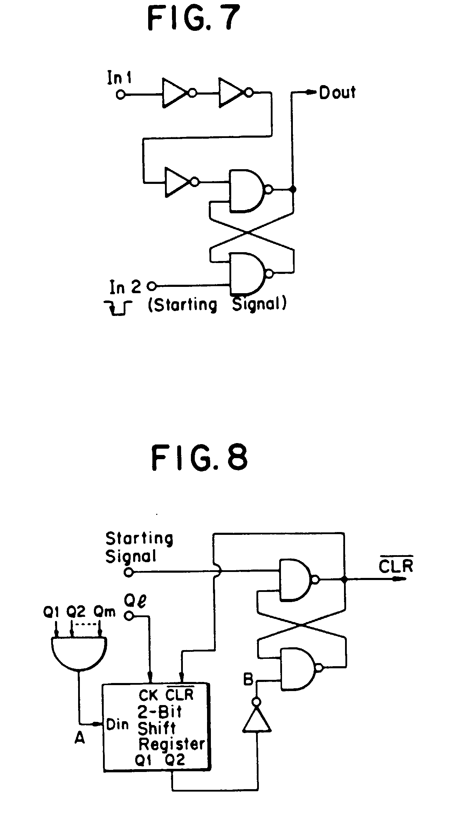

Figure 7 shows the configuration of the initial data setting/resetting circuit 88 of the flash-clear circuit 62 described above. Referring to Figure 7, the initial data setting/resetting circuit 88 includes a set/reset type flip- flop which is connected to receive at a first input terminal In1 an lth bit output Ql of the l-bit counter 85 and to receive a starting signal at a second input terminal In2 thereof, and three inverters for delaying such lth bit output Ql of the l-bit counter 85 to be received by the flip-flop.

Referring now to Figure 8, there is shown the configuration of the initial clearing and count-up clearing circuit 89 of the flash-clear circuit 62. The initial clearing and count-up clearing circuit 89 includes an AND circuit for obtaining a logical product of output bit signals Q1, Q2, ... Qm of the m-bit counter 86, a 2-bit shift register for receiving an output signal from the AND circuit, an inverter for inverting a second-bit output Q2 of the shift register, and a flip-flop for receiving an output signal of the inverter as a reset signal. The two-bit shift register receives an lth-bit signal Ql of the l-bit counter as a clock pulse and also receives at its clear terminal an clear signal CLR which is an output of the flip-flop of the initial clear and count-up clear circuit 89.

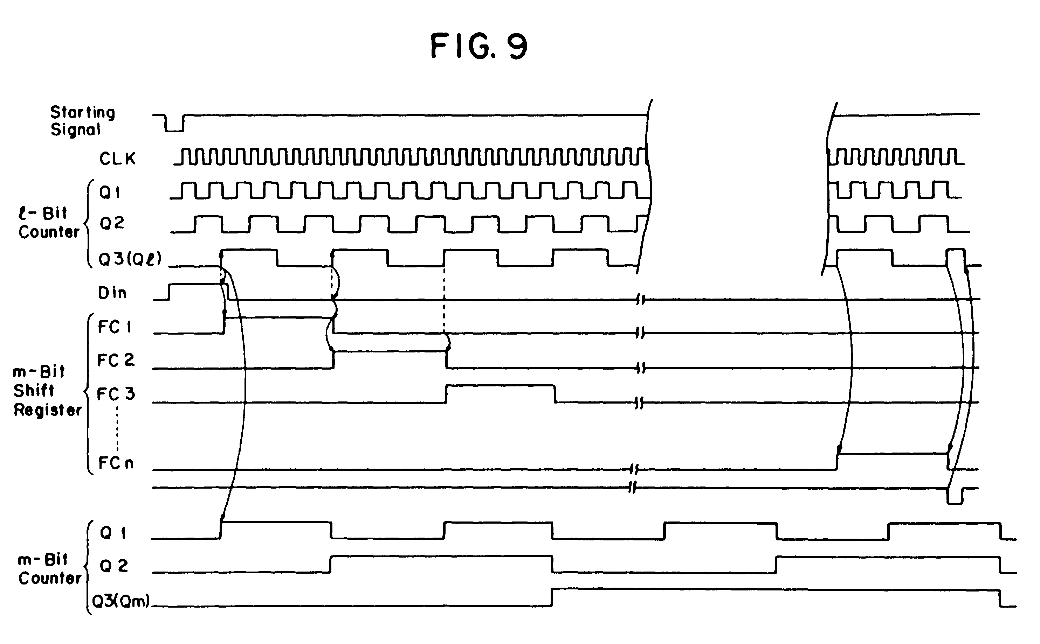

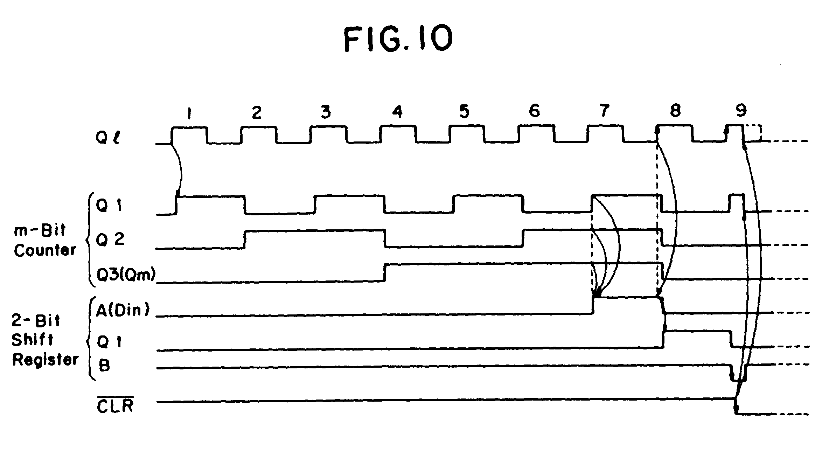

Figures 9 and 10 illustrate the operation of the flash-clear circuit 62 shown in Figure 6. Referring first to Figure 9, when a starting signal is received from the starting circuit 61 shown in Figure 4 or changed from a high level to a low level, each of the ring oscillator 84, the l-bit counter 85, the m-bit counter 86 and the n-bit shift register 87 are initially cleared by an output CLR of the initial clearing and count-up clearing circuit 89. Then, when the starting signal subsequently rises from the low level to a high level, the ring oscillator 64 starts generation of clock pulses CLK, and the l-bit counter 85 counts the clock pulses CLK. When the final or lth-bit output Ql of the l-bit counter 85 finally rises to a high level, the first-bit output Q1 of the m-bit counter 86 rises to a high level, and at the same time, the initial data setting/resetting circuit 88 is enabled to deliver an output Dout of a high level as initial data Din to the n-bit shift register 87. Consequently, a first flash clear signal FC1 is supplied from the n-bit shift register 87 to the first memory cell group 63₁. Immediately after that, the initial data Din falls to a low level and is thereafter maintained at the low level. In order to prevent the initial data Din from falling at a timing before clearing of the n-bit counter 87 is completed, the initial data setting/resetting circuit 88 includes the plurality of delaying inverters on the input In1 side of the flip-flop as shown in Figure 7.

When the lth-bit output Ql of the l-bit counter 85 subsequently rises again, the initial data in the n-bit shift register 87 is shifted. Consequently, a flash clear signal FC2 is delivered from the second-bit output Q2 of the n-bit shift register 87. In this manner, flash clear signals FC1 to FCn are delivered successively from the n-bit shift register 87.

Then, when such flash clear signals FC1 to FCn have thus been delivered, all of the outputs Q1 to Qm (m = 3 in the waveform chart shown in Figure 10) of the m-bit counter 86 are turned to a high level as shown in Figure 10 so that a signal A at the high level is introduced to the 2-bit shift register (Figure 8) of the initial clearing and count-up clearing circuit 89. Then, in response to a rising edge of a subsequent signal Ql (output signal of the l-bit counter), the signal A is supplied from the first-bit output Q1 of the 2-bit shift register. The output, however, is not used. Then, the signal A is shifted to a second bit of the 2-bit shift register in response to a rising edge of the next signal Ql. The output signal from the second bit of the 2-bit shift register is inverted by the inverter and introduced as a reset signal to the flip-flop in the initial clear and count-up clear circuit 87. As a result, the clear signal CLR is changed over from a high level to a low level consequently to halt operation of all of the ring oscillator 84, the l-bit counter 85, the m-bit counter 86 and the n-bit shift register 87, thereby completing the series of flash-clearing operations.

With the flash-clear circuit used in the memory device, setting of a clearing time can be made with a high degree of accuracy by selectively determining the oscillation frequency of the ring oscillator 87 and the count values of the two counters 85 and 86.

It is to be understood that although the starting signal is based on the negative logic in the memory device described above, it may instead be based on the positive logic. In the latter case, however, it is necessary to provide a logic inverter for each input terminal that receives such a starting signal.

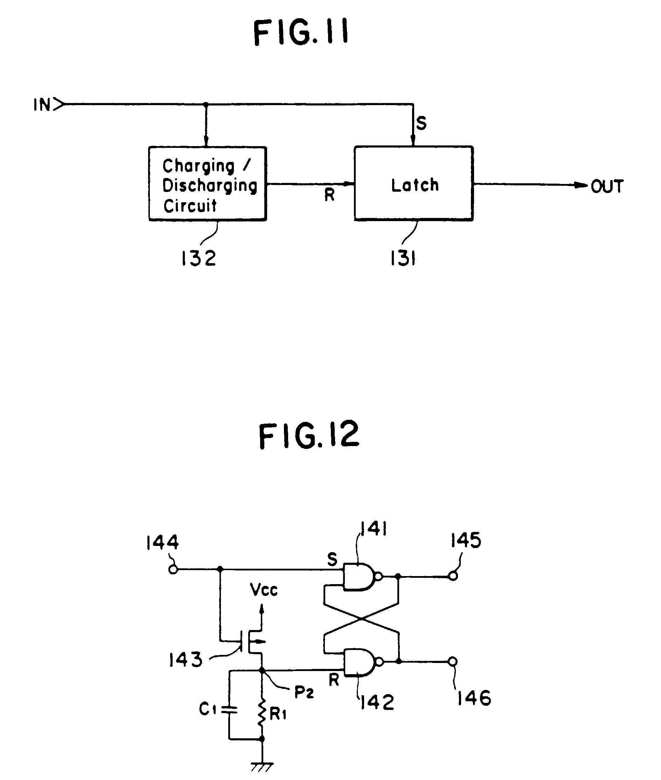

The starting circuit 61 for producing a starting signal to start the flash-clear circuit 62 shown in Figure 4 may be constituted, for example, from a pulse generator which may have a basic constitution as shown in Figure 11.

Referring to Figure 11, the pulse generator includes a latch circuit 131 and a charging/discharging circuit 132. An input pulse is received at a set terminal S of the latch circuit 131 and also be the charging/discharging circuit 132. The output of the charging/discharging circuit 132 is fed as a reset signal to a reset terminal R of the latch circuit 131. An output pulse of the pulse generator is delivered from the latch circuit 131.

In operation, at first the latch circuit 131 is set by an input pulse received to cause a rise (or otherwise a fall) of the output thereof. The input pulse is simultaneously fed also to the charging/discharging circuit 132 to cause the latter to make a charging operation or a discharging operation, or else charging and discharging operations. Consequently, the output level of the charging/discharging circuit 132 varies in accordance with the operation thereof thus made. When the output level crosses the threshold voltage at the terminal R of the latch circuit 131, the latch circuit 131 is reset to cause a fall (or a rise) of the output thereof.

With the pulse generator described above, the duration of the output pulse depends upon a charging or discharging characteristic of the charging/discharging circuit 132. Accordingly, an output pulse of a desired duration can be obtained from the pulse generator.

A more detailed circuit construction of the pulse generator is shown in Figure 12. Referring to Figure 12, the pulse generator includes a charging/discharging circuit composed of a resistor R1, a capacitor C1 and a PMOS transistor 143. The pulse generator further includes an SR latch circuit composed of a pair of 2-input NAND circuits 141 and 142 for receiving input pulses based on the negative logic.

The pulse generator has an input terminal 144 at which it receives a negative logic input pulse. The input terminal 144 is connected to the PMOS transistor 143 and also to the S terminal of the NAND circuit 141 of the latch circuit. The output terminal of the NAND circuit 141 is connected to a first output terminal 145 of the pulse generator and also to an input terminal of the other NAND circuit 142 of the latch circuit. The output terminal of the NAND circuit 142 is connected to a second output terminal 146 of the pulse generator and also to the other input terminal of the NAND circuit 141 of the latch circuit.

The gate of the PMOS transistor 143 of the charging/discharging circuit is connected to the input terminal 144 of the pulse generator while the source is connected to a supply voltage Vcc. The drain of the PMOS transistor 143 is connected to a terminal of each of the resistor R1 and the capacitor C1 and also to the R terminal of the NAND circuit 142. The resistor R1 and the capacitor C1 are connected in parallel to each other, and a ground voltage GND is applied in common to the other terminals of the resistor R1 and the capacitor C1.

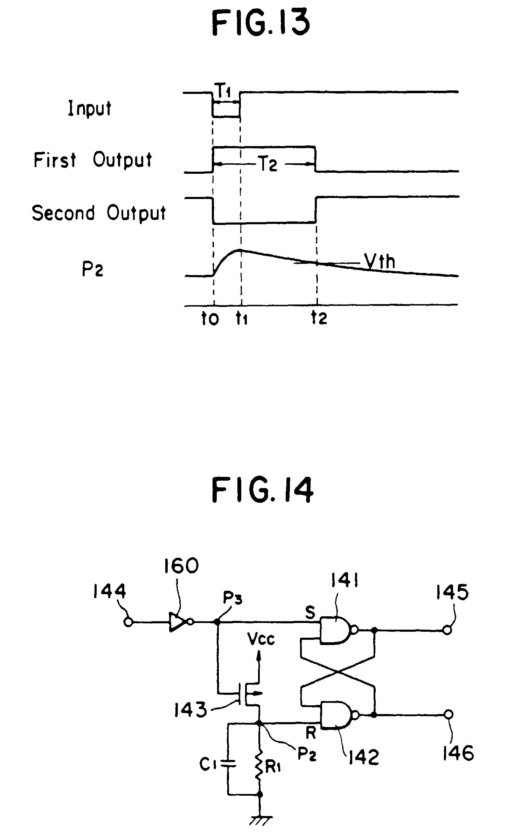

Figure 13 illustrates the operation of the pulse generator shown in Figure 12. Referring to Figure 13, the voltage at a junction P2 between the PMOS transistor 143, the resistor R1, the capacitor C1 and the NAND circuit 142 shown in Figure 12 initially exhibits a low level, and accordingly, the output of the NAND circuit 142 which provides a second output to be delivered from the second output terminal 146 remains at a high level. Thus, the two input terminals of the NAND circuit 141 are both at a high level so that a first output to be delivered from the first output terminal 145 presents a low level.

Then, at an instant t0, a low-level input pulse is received at the input terminal 144. Thereupon, the output of the NAND circuit 141 is changed to a high level. The low-level input pulse is simultaneously fed also to the gate of the PMOS transistor 143 to turn on the PMOS transistor 143. Consequently, the voltage at the junction P2 is gradually raised from the initial low level, while charging the capacitor, towards a high level substantially equal to the supply voltage Vcc. Then, at an instant when the voltage at the junction P2 crosses the input threshold voltage of the NAND circuit 142, the output of the NAND circuit 142 is changed from a high level to a low level.

Then, at an instant t1 after lapse of a time T1 from the instant t0, the pulse is changed from the low level to a high level. However, no logic change is caused in the NAND circuit 141 by the level change of the input pulse at the input terminal 144 because the output of the NAND circuit 142 received at the other input terminal of the NAND circuit 141 is already at a low level. Instead, the PMOS transistor 143 is switched from an on-state to an off-state in response to the level change of the input pulse. Consequently, the junction P2 is disconnected from the supply voltage Vcc so that discharging is started by the capacitor C1 and the resistor R1.

When discharging by the capacitor C1 and the resistor R1 proceeds until the potential at the junction P2 crosses the threshold voltage Vth at the R terminal of the NAND circuit 142, that is, until an instant t2 at which a reset signal is supplied to the NAND circuit 142, the output of the NAND circuit 142 is changed from a low level to a high level. Consequently, the output of the second output terminal 146 of the pulse generator is changed to a high level at that time. Since the output of the NAND circuit 142 is fed also to the NAND circuit 141, the two input terminals of the NAND circuit 141 are both changed to a high level so that the output of the NAND circuit 141 is changed to a low level.

With the pulse generator shown in Figure 12, the time T2 from the instant t1 to the instant t2 is equal to the duration of an output pulse. Therefore, it is possible to establish a desired pulse duration which does not depend upon the duration T1 of an input pulse. For example, even if the input pulse duration T1 is 10 nsec or so, the output pulse duration T2 can be set to 1 second or so. The time T2 is determined by a discharging characteristic or time constant of the capacitor C1 and the resistor R1 as described hereinabove. Therefore, the output pulse duration T2 can be adjusted as desired by suitably selecting the values of the capacitor C1 and the resistor R1, or the concentration of the impurities or the dielectric material and the like.

In addition, both positive and negative pulses can be produced without provision of any additional gate circuit. Accordingly, the number of elements can be decreased significantly compared with a previously-proposed pulse generator using a row of inverters.

Another circuit configuration of the pulse generator is shown in Figure 14. The pulse generator shown in Figure 14 is a modification to the pulse generator shown in Figure 12 for receiving an input pulse based on the positive logic.

Referring to Figure 14, the pulse generator includes an RS latch circuit composed of a NAND circuit 141 and a NAND circuit 142, and a charging/discharging circuit composed of a PMOS transistor 143, a capacitor C1 and a resistor R1, similarly to the pulse generator shown in Figure 12. Since the RS latch circuit and the charging/discharging circuit are similar to those of the pulse generator shown in Figure 12, like reference symbols are used to denote like elements, and further description thereof will be omitted.

The pulse generator shown in Figure 14 is different from the pulse generator shown in Figure 12 in that an inverter 160 is connected to an input terminal 144, and the output of the inverter 160 is connected to a junction P3 between the gate of the PMOS transistor 143 and the S terminal of the NAND circuit 141.

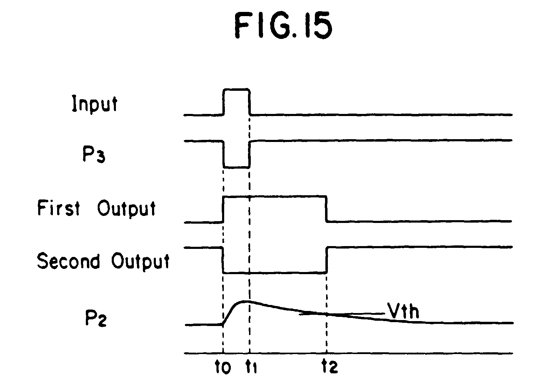

In operation, when an input pulse based on the positive logic is received at the input terminal 144 of the pulse generator, it is inverted by the inverter 160 to make a signal of a low level at the junction P3 shown in Figure 15. The signal level at the junction P3 corresponds to the level of the input pulse at the input terminal 144 in the pulse generator shown in Figure 12. Thus, the pulse generator operates in response to an input pulse based on the positive logic in a quite similar manner to the pulse generator shown in Figure 12 which operates in response to an input pulse based on the negative logic.

Particularly when any one of the pulse generators shown in Figures 11, 12 and 14 is used in an SRAM device, a resistor formed by the same process as a high-resistance element for the memory cells can be used as the resistor R1 of the charging/discharging circuit, which will eliminate the necessity for a great capacity.

It is possible to apply any of the pulse generators to a flash clear mechanism of a video RAM or the like.

While the charging/discharging circuit described above is designed so as to be reset principally by a discharge, it may be replaced by a charging/discharging circuit which is designed to be reset by a charge. Further, the RS latch circuit may be composed of a NOR circuit or circuits instead of NAND circuits.

With the pulse generators as described above, the pulse duration can be expanded independently of the pulse duration of an input pulse based on the charging and discharging characteristics of the charging/discharging circuit, and the output pulse duration can be adjusted as desired in accordance with the selected values of the component resistor and capacitor which constitute the pulse generator. Furthermore, the entire circuit configuration can be simplified when any of the pulse generators is used, and both positive and negative pulses can be produced simultaneously. In addition, any of the pulse generators can be applied to a variety of semiconductor IC devices.

## Claims

1. A semiconductor memory device having a flash-clear function, the memory device comprising:
a memory cell array (63) segmented into a plurality of memory cell groups (63₁ to 63ₙ); and being characterised by:
a single flash-clear circuit (62) provided in common for said plurality of memory cell groups (63₁ to 63ₙ) for delivering, during a distinct flash-clearing operation, flash-clearing signals (FC1 to FCn) at different timings to respective ones of said plurality of memory cell groups to flash-clear memory cells of said plurality of memory cell groups.

2. A memory device according to claim 1, wherein said flash-clear circuit (62) includes a shift register (87).

3. A memory device according to claim 2, wherein said flash-clear circuit (62) includes a ring oscillator (84) for generating clock pulses, a counter (85) for setting a flash-clearing time for each of said memory cell groups and for counting a number of said memory cell groups, the shift register (87) being operable to supply the flash-clearing signals (FC1 to FCn) at successively delayed timings in a particular order to said memory cell groups, and an initial data setting/resetting circuit (88) for providing data to said shift register (87).

4. A memory device according to claim 1, claim 2 or claim 3, including a starting circuit (61) for starting said flash-clear circuit (62), said starting circuit (61) comprising:
a latch circuit (131) operable to be set by an input pulse and to deliver a predetermined output pulse; and
a charging/discharging circuit (132) for receiving the input pulse;
said latch circuit (131) being connected to be reset in response to charging or discharging of said charging/discharging circuit (132).

5. A memory device according to claim 4, wherein said charging/discharging circuit includes a resistor (R1), a capacitor (C1), and a MOS transistor (143) for connecting a power source voltage (Vcc) to said resistor (R1) and said capacitor (C1).

## Patentansprüche

1. Halbleiterspeichereinrichtung mit einer Blitz-Löschfunktion, wobei die Speichereinrichtung aufweist:
- ein Speicherzellenfeld (63), das in mehrere Speicherzellengruppen (63₁ bis 63ₙ) segmentiert ist und gekennzeichnet ist durch
- eine einzige Blitz-Löschschaltung (62), die gemeinsam für die mehreren Speicherzellengruppen (63₁ bis 63ₙ) vorgesehen ist, um während eines bestimmten Blitz-Löschbetriebes Blitz-Löschsignale (FC1 bis FCn) mit unterschiedlichen Zeitgebungen an die jeweiligen der mehreren Speicherzellengruppen abzugeben, um ein Blitz-Löschen von Speicherzellen der mehreren Speicherzellengruppen durchzuführen.

2. Speichereinrichtung nach Anspruch 1, bei der die Blitz-Löschschaltung (62) ein Schieberegister (87) enthält.

3. Speichereinrichtung nach Anspruch 2, bei der die Blitz-Löschschaltung (62) einen Ringoszillator (84), um Zeittaktimpulse zu erzeugen, einen Zähler (85), um eine Blitz-Löschzeit für jede Speicherzellengruppe einzustellen, und um eine Anzahl Speicherzellengruppen zu zählen, wobei das Schieberegister (87) so betreibbar ist, daß die Blitz-Löschsignale (FC1 bis FCn) mit nacheinanderfolgend verzögerten Zeitgebungen in spezieller Reihenfolge den Speicherzellengruppen zuzuführen, und eine Anfangsdaten-Setz/Rücksetzschaltung (88) enthält, um Daten für das Schieberegister vorzusehen.

4. Speichereinrichtung nach Anspruch 1, Anspruch 2 oder Anspruch 3, mit einer Startschaltung (61), um die Blitz-Löschschaltung (62) zu starten, wobei die Startschaltung (61) aufweist:
- eine Zwischenspeicherschaltung (131), die betreibbar ist, um einen Eingangsimpuls einzustellen, und um einen vorbestimmten Ausgangsimpuls abzugeben, und
- eine Lade/Entladeschaltung (132), um die Eingangsimpulse zu empfangen,
- wobei die Zwischenspeicherschaltung (131) zum Rücksetzen auf das Laden oder Entladen der Lade/Entladeschaltung (132) hin angeschlossen ist.

5. Speichereinrichtung nach Anspruch 4, bei der die Lade/Entladeschaltung einen Widerstand (R1), einen Kondensator (C1), und einen MOS-Transistor (143) enthält, um eine Versorgungsspannung (Vcc) mit dem Widerstand (R1) und dem Kondensator (C1) zu verbinden.

## Revendications

1. Dispositif de mémoire à semiconducteurs ayant une fonction d'effacement éclair, le dispositif de mémoire comprenant :
une matrice de cellules de mémoire (63) segmentée en une pluralité de groupes de cellules de mémoire (63₁ à 63ₙ) ;
et qui est caractérisé par :
un seul circuit d'effacement éclair (62) prévu en commun pour ladite pluralité des groupes de cellules de mémoire (63₁ à 63ₙ) pour fournir, pendant une opération d'effacement éclair distincte, des signaux d'effacement éclair (FC1 à FCn) à différents temps de synchronisation aux groupes respectifs de ladite pluralité des groupes de cellules de mémoire pour un effacement éclair des cellules de mémoire de ladite pluralité des groupes de cellules de mémoire.

2. Dispositif de mémoire selon la revendication 1, dans lequel ledit circuit d'effacement éclair (62) comprend un registre à décalage (87).

3. Dispositif de mémoire selon la revendication 2, dans lequel ledit circuit d'effacement éclair (62) comprend un oscillateur en anneau (84) pour engendrer des impulsions d'horloge, un compteur (85) pour établir un temps d'effacement éclair pour chacun desdits groupes de cellules de mémoire et pour compter un nombre desdits groupes de cellules de mémoire, le registre a décalage (87) pouvant être mis en fonctionnement pour fournir les signaux d'effacement éclair (FC1 à FCn) à des temps de synchronisation successivement retardés dans un ordre particulier auxdits groupes de cellules de mémoire, et un circuit d'établissement/de suppression de données initiales (88) pour fournir des données audit registre à décalage (87).

4. Dispositif de mémoire selon la revendication 1, la revendication 2 ou la revendication 3, incluant un circuit de déclenchement (61) pour déclencher ledit circuit d'effacement éclair (62), ledit circuit de déclenchement (61) comprenant :
un circuit de verrouillage (131) pouvant être mis en fonctionnement pour le positionner par une impulsion d'entrée et pour qu'il fournisse une impulsion de sortie prédéterminée ; et,
un circuit de charge/de décharge (132) pour recevoir l'impulsion d'entrée ;
ledit circuit de verrouillage (131) étant connecté pour le remettre à l'état initial en réponse à la charge ou à la décharge dudit circuit de charge/de décharge (132).

5. Dispositif de mémoire selon la revendication 4, dans lequel ledit circuit de charge/de décharge comprend une résistance (R1), un condensateur (C1), et un transistor MOS (143) pour connecter une source de tension d'alimentation (Vcc) à ladite résistance (R1) et audit condensateur (C1).
